# EUROPEAN PATENT APPLICATION

(11) **EP 1 420 449 A1**
(43) Date of publication of application: **19.05.2004**
(21) Application number: 03257168.9
(22) Date of filing: 13.11.2003
(51) Int. Cl.: H01L 23/544

(54) **Device manufacturing method with reversed alignment markers**

(30) Priority: 13.11.2002 EP 02257846
(71) Applicant: ASML Netherlands B.V., 5503 LA Veldhoven (NL)
(72) Inventor: Best, Keith Frank, Prunedale California 93907 (US); Consolini, Joseph J., Costa Mesa California 92626 (US); Friz, Alexander, San José California 95130 (US)
(74) Representative: Leeming, John Gerard

(57) **Abstract**

A device manufacturing method comprising the steps of:
providing a first substrate having first and second surfaces;
patterning said first surface of said substrate with at least one reversed alignment marker;
providing a protective layer over said alignment marker(s);
bonding said first surface of said first substrate to a second substrate;
locally etching said first substrate as far as said protective layer to form a trench around the or each reversed alignment marker; and
forming at least one patterned layer on said second surface using a lithographic projection apparatus having a front-to-backside alignment system whilst aligning said substrate to the alignment markers revealed in the or each trench.

## Description

The present invention relates to device manufacturing methods using lithographic projection apparatus comprising:
- a radiation system for supplying a projection beam of radiation;
- patterning means for patterning the projection beam according to a desired pattern;
- a substrate table for holding a substrate; and
- a projection system for imaging the patterned beam onto a target portion on a first side of the substrate.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

Alignment is the process of positioning the image of a specific point on the mask to a specific point on the wafer which is to be exposed. Typically one or more alignment marks, such as a small pattern, are provided on each of the substrate and the mask. A device may consist of many layers which are built up by successive exposures with intermediate processing steps. Before each exposure, alignment between the markers on the substrate and the mask is performed to minimize any positional error between the new exposure and the previous ones, which error is termed overlay error.

For some devices, e.g. micro-electro-mechanical systems (MEMS) and micro-opto-electro-mechanical systems (MOEMS), it is desirable to be able to create structures on both sides of a substrate using lithographic processes and in many cases, the structures on opposite sides of the substrate need to be aligned with each other. This means that it is necessary for the lithographic apparatus to align the pattern being projected onto the frontside of a substrate to alignment markers on the backside. This can be done with additional hardware, e.g. optics to project an image of a backside marker to the front side of the substrate or using a substrate that is transparent. Infra-red radiation can be used with a silicon substrate but has limited accuracy and may undesirably heat the wafer.

It is an object of the present invention to provide a device manufacturing method which can print structures on one side of a substrate aligned to markers on the other side without the need for additional hardware and with improved accuracy.

This and other objects are achieved according to the invention in a device manufacturing method comprising:
providing a first substrate having first and second surfaces;
patterning said first surface of said substrate with at least one reversed alignment marker;
providing a protective layer over said alignment marker(s);
bonding said first surface of said first substrate to a second substrate;
locally etching said first substrate as far as said protective layer to form a trench around the or each reversed alignment marker; and
forming at least one patterned layer on said second surface using a lithographic projection apparatus having a front-to-backside alignment system whilst aligning said substrate to the alignment markers revealed in the or each trench.

The reversed alignment marker formed in the first surface is revealed by the etch as a normally oriented alignment marker to which the lithographic projection apparatus can readily align. Patterns directly aligned to the marker printed on the frontside can therefore be printed on the backside of the substrate.

The protective layer which conforms to the shape of the marker is preferably formed of a material, e.g. SiO₂, selective against the etch used to form the trench(es) and hence forms an etch stop layer. A reflective layer, e.g. of Al, can be formed over the protective layer (before bonding) to increase the visibility of the marker when revealed in the trench.

The etch step can be localized by forming an etch-resistant layer, e.g. of oxide, on the second surface; providing a layer of radiation-sensitive resist on the etch-resistant layer; patterning and developing said resist so as to form openings above said marker(s); and removing said etch-resistant layer in said openings. To pattern the resist to form the openings, the markers only need to be located coarsely, which can be done to sufficient degree of accuracy using an infra-red mark sensor from the second side of the substrate.

Before the substrate is bonded to the second (carrier) substrate, devices may be formed in and/or on the first surface using known techniques. The protective layer and optional reflective layer may be formed as part of device layers, with any intervening layers locally removed as necessary, rather than being specially formed.

Normal alignment markers for use in aligning the structures in or on the first surface can be printed in the same step as the reverse alignment markers used to align the structures formed on the second surface. In this way, the positional relationship of the normal and reversed markers and hence of the structures on the first and second surfaces can be assured.

After bonding, the first substrate may be reduced in thickness, e.g. by grinding.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

Embodiments of the invention will now be described, by way of example only, with reference to the accompanying schematic drawings in which:
Figure 1 depicts a lithographic projection apparatus which can be used in the method of the invention;
Figure 2 is a plan view of a substrate showing the location of alignment markers used in eth method of the invention; and
Figures 3 to 8 illustrate steps in a method of manufacturing devices according to the invention.

In the Figures, corresponding reference symbols indicate corresponding parts.

### Lithogrohic Projection Apparatus

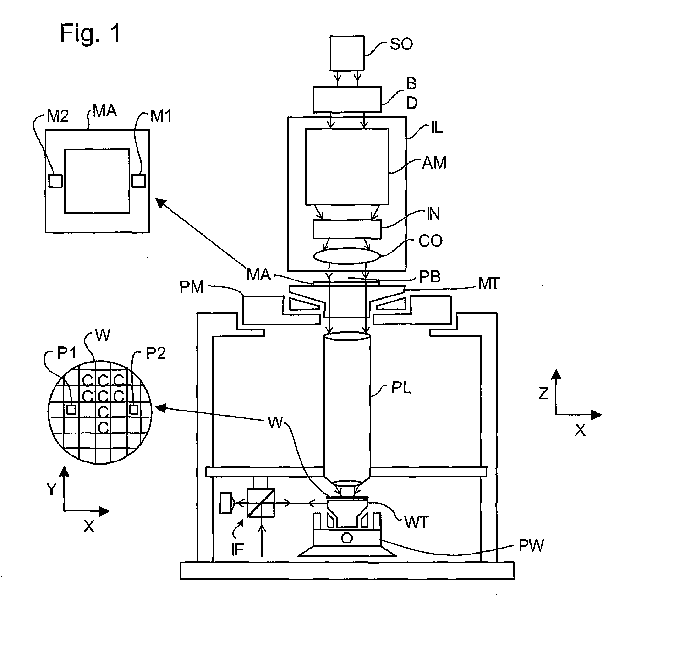

Figure 1 schematically depicts a lithographic projection apparatus which can be used to perform steps of the method of the invention. The apparatus comprises:
- an illumination system (illuminator) IL for providing a projection beam PB of radiation (e.g. UV radiation or DUV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a refractive projection lens) PL for imaging a pattern imparted to the projection beam PB by patterning means MA onto a target portion C (e.g. comprising one or more dies) of the substrate W.

As here depicted, the apparatus is of a transmissive type (e.g. employing a transmissive mask). Alternatively, the apparatus may be of a reflective type (e.g. employing a programmable mirror array of a type as referred to above).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the projection beam PB, having a desired uniformity and intensity distribution in its cross-section.

The projection beam PB is incident on the mask MA, which is held on the mask table MT. Having traversed the mask MA, the projection beam PB passes through the lens PL, which focuses the beam onto a target portion C of the substrate W. With the aid of the second positioning means PW and position sensor IF (e.g. an interferometric device), the substrate table WT can be moved accurately, e.g. so as to position different target portions C in the path of the beam PB. Similarly, the first positioning means PM and another position sensor (which is not explicitly depicted in Figure 1) can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:
1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

### Embodiment 1

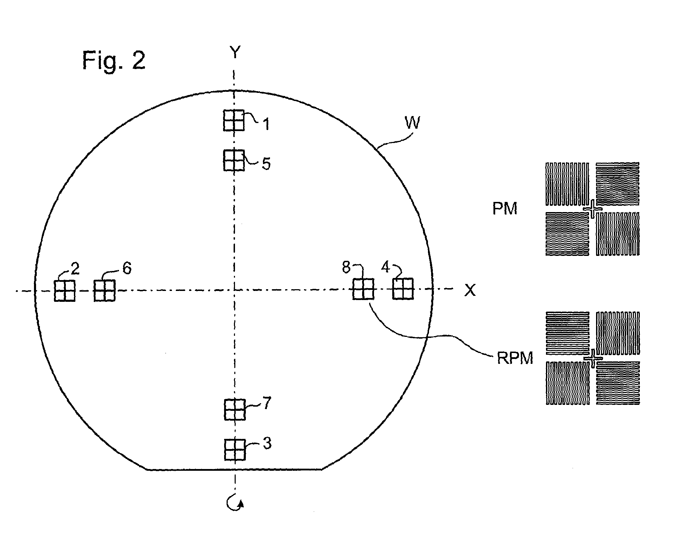

Figure 2 shows a wafer W which is to be provided with devices on both sides and on which are provided normal markers (not shown) and reversed markers 1-8. The reversed markers 1-8 are mirror images - about the axis about which the wafer is to be rotated, in this case the Y axis - of the normal markers. The normal markers may take any convenient form, such as a grating, a group of gratings, box-in-box, frame-in-frame, chevrons, etc., as known in the art, and may form the primary markers used for global alignment of the substrate prior to a series of exposures. In Figure 2, examples of a reverse primary marker and, for reference, a normal primary marker, each formed by four gratings, are shown. Of the four gratings, a pair are horizontal and a pair vertical and, though not apparent from the drawing, the two gratings of each pair have different periods in a known manner. In the present example the markers are provided at symmetrical positions on the wafer axes. The present invention may of course also be applied to other markers, e.g. markers adjacent each target area or die.

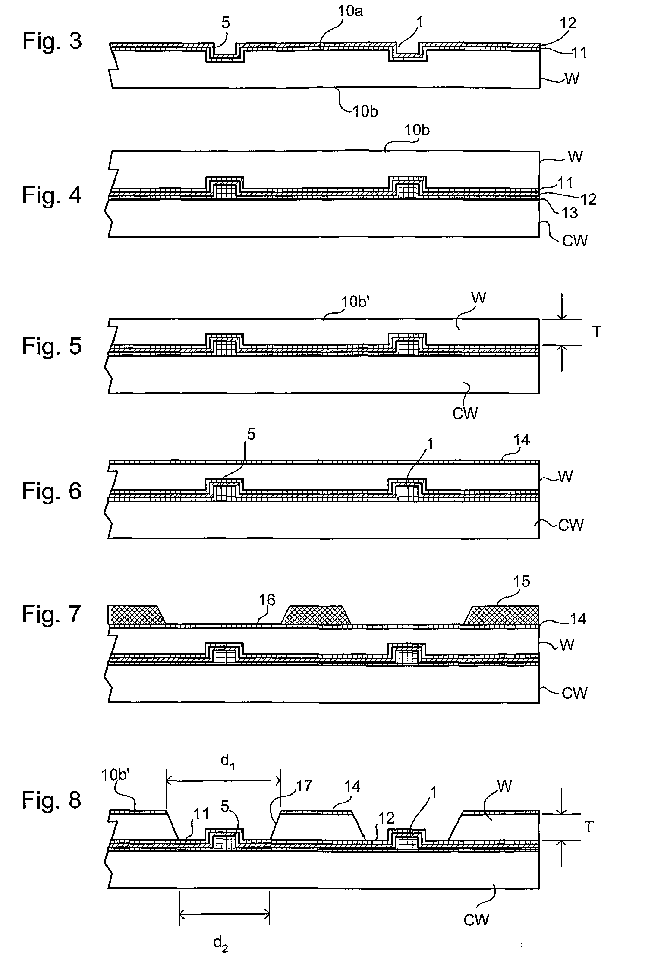

Figures 3 to 8 illustrate steps in an example of the method of the invention. Firstly, normal markers (not shown) and reversed markers 1-8 are etched into first surface 10a of wafer W in a known manner and covered by a protective layer 11 of SiO₂ and a reflective layer 12 of Al, as shown in Figure 3, which is a partial cross-section along the Y axis of Figure 2. The substrate W is then flipped over and bonded to carrier substrate CW with a layer of adhesive 13. Figure 4 shows the substrate W bonded to the carrier substrate CW, with the second surface 10b uppermost.

As shown in Figure 5, the wafer W is ground to a desired thickness, T, e.g. of about 70µm, and the upper surface 10b' finished as required for the devices to be formed on it.

To locally etch through the first substrate to reveal the reversed markers 1-8, the second surface 10b' is first covered with a layer of oxide 14, e.g. by deposition, as shown in Figure 6 and a layer of resist 15 which is exposed to open primary flood windows 16 above the reversed markers 1-8. Since the primary flood windows 16 are rather larger than the markers they do not have to be accurately located and the exposure step to form them can be carried out after the markers have been located using a coarse alignment tool, such as a mark sensor using infra-red, that can detect the reversed markers through the substrate W.

The oxide layer 14 is removed in the windows 16 by a dry etch RIE or wet etch (Buffered Oxide Etch Containing HF) step to form a hardmask and a deep trench etch using an etchant selective to Si is performed to form trenches 17. The deep trench etch ends on the SiO₂ layer and so the trenches 17 extend down to the reversed primary markers 1, 5 to reach the position shown in Figure 8. Thereafter, device layers can be formed on the second surface 10b' with alignment to the reversed markers 1-8 revealed in trenches 17. The trenches have a width d₁ at their tops that is sufficient, e.g. 1200µm, to ensure that the width d₂ at their base is large enough, e.g. 1000µm, to accommodate comfortably the markers 1-8. The oxide layer 14 is then removed prior to continued processing.

The first step in continued processing of the bonded substrate may be to print further markers, at known positions relative to the revealed markers, on the second surface 10b', now uppermost, of the wafer. The further markers can be aligned to in the further processing of the second surface more conveniently than the revealed markers.

Whilst specific embodiments of the invention have been described above, it will be appreciated that the invention may be practiced otherwise than as described. The description is not intended to limit the invention.

## Claims

1. A device manufacturing method comprising the steps of:
providing a first substrate having first and second surfaces;
patterning said first surface of said substrate with at least one reversed alignment marker;
providing a protective layer over said alignment marker(s);
bonding said first surface of said first substrate to a second substrate;
locally etching said first substrate as far as said protective layer to form a trench around the or each reversed alignment marker; and
forming at least one patterned layer on said second surface using a lithographic projection apparatus having a front-to-backside alignment system whilst aligning said substrate to the alignment marker(s) revealed in the or each trench.

2. A method according to claim 1 wherein said protective layer is formed of a material, e.g. SiO₂, selective against the etch used to form the trench(es) and hence forms an etch stop layer.

3. A method according to claim 1 or 2 comprising the further step of forming a reflective layer, e.g. of Al, over the protective layer prior to said step of bonding to increase the visibility of the marker when revealed in the trench.

4. A method according to claim 1, 2 or 3 comprising the further step, before said step of bonding, of forming devices in and/or on the first surface.

5. A method according to claim 4 wherein said protective layer, and/or said reflective layer if provided, are formed as part of device layers, with any intervening layers locally removed as necessary

6. A method according to claim 4 or 5 wherein normal alignment markers for use in aligning the structures in or on the first surface are printed in the same step as said reverse alignment markers.

7. A method according to any one of the preceding claims wherein said step of locally etching comprises the substeps of forming an etch-resistant layer, e.g. of oxide, on the second surface; providing a layer of radiation-sensitive resist on the etch-resistant layer; patterning and developing said resist so as to form openings above said marker(s); and removing said etch-resistant layer in said openings.

8. A method according to any one of the preceding claims comprising the further step, after said step of bonding, of reducing the thickness of said first substrate, e.g. by grinding.

9. A method according to any one of the preceding claims wherein said alignment marker(s) is(are) patterned using the same apparatus as is used for patterning the process layers.

10. A method according to any one of the preceding claims wherein said step of forming at least one patterned layer on said second surface includes the formation of at least one further alignment marker at a known position relative to the alignment marker(s) revealed in the or each trench.
